# EUROPÄISCHE PATENTSCHRIFT

(11) **EP 1 176 639 B1**
(45) Veröffentlichungstag und Bekanntmachung des Hinweises auf die Patenterteilung: **20.06.2007**
(21) Anmeldenummer: 00116427.6
(22) Anmeldetag: 28.07.2000
(51) Int. Cl.: H01L 23/482, H01L 21/60

(54) **Verfahren zur Kontaktierung eines Halbleiterbauelementes**
Method for contacting a semiconductor chip
Procédé de réalisation d'un contact sur un dispositif à semi-conducteur

(43) Veröffentlichungstag der Anmeldung: 30.01.2002
(73) Patentinhaber: Infineon Technologies AG, 81669 München (DE)
(72) Erfinder: Hübner, Holger, Dr., 85598 Baldham (DE); Kripesh, Vaidyana Than, Dr., Chennai 600 083, Ashok Nagar (IN)
(74) Vertreter: Epping - Hermann - Fischer

(56) Entgegenhaltungen:
- EP-A- 0 426 303
- EP-A- 0 530 780
- DE-A- 19 531 158
- US-A- 4 811 170
- R.S RAI, S.K. KANG, AND S. PURUSHOTHAMAN: "Interfacial Reactions with Lead (Pb)-Free Solders" 1995 PROCEEDINGS. 45TH ELECTRONIC COMPONENTS AND TECHNOLOGY CONFERENCE, 24. Mai 1995 (1995-05-24), Seiten 1197-1202, XP001001461 Las Vegas
- MORRIS JR J W ET AL: "MICROSTRUCTURE AND MECHANICAL PROPERTIES OF SN-IN AND SN-BI SOLDERS" , JOM,US,MINERALS, METALS AND MATERIALS SOCIETY, WARRENDALE, VOL. 45, NR. 7, PAGE(S) 25-27 XP000383230 ISSN: 1047-4838 * das ganze Dokument *

## Beschreibung

Die vorliegende Erfindung betrifft ein Verfahren zur Kontaktierung eines Halbleiterbauelementes mit einer Metallisierung auf einer Folie.

Mit elektrisch leitenden Klebstoffen lassen sich elektrisch leitende Verbindungen auch bei einer niedrigen Verarbeitungstemperatur herstellen. Viele derartige Kleber brauchen zum Aushärten aber bereits höhere Temperaturen, bei denen das Kunststoffmaterial einer Folie beschädigt wird oder eine darauf aufgebrachte Metallisierung abgelöst wird. Zudem ist die elektrische Leitfähigkeit für viele Anwendungen nicht ausreichend, und die hergestellte Verbindung ist empfindlich gegenüber Feuchtigkeit. Insbesondere, wenn ein Kontakt eines elektronischen Bauelementes (z. B. eines Si-IC-Chips) elektrisch leitend mit einer Metallschicht (z. B. aus Kupfer oder Nickel) einer metallisierten Kunststofffolie verbunden werden soll, bei der die Grenze der Temperaturbelastbarkeit bei etwa 120°C liegt und bei der die aufgebrachte Metallschicht sehr dünn ist (typisch etwa 100 nm), ist es schwierig, mit leitfähigem Klebstoff eine ausreichend dauerhafte und gut leitende Verbindung herzustellen, die nicht ohne Zerstörung der Folie lösbar ist.

Die EP 0 426 303 A2 gibt ein Lötverfahren an, bei dem auf ein flexibles Substrat aus einer mit einer Kupferschicht versehenen Polyimidfolie (Markenname Pyralux) mittels Flip-Chip-Montage ein Halbleiterchip aufgelötet wird. Beim Lötvorgang erhöht sich die Schmelztemperatur des verwendeten eutektischen Lotes.

Die US 4,811,170 beschreibt einen entsprechenden Lötprozess, bei dem auf Kontaktflächen von Leiterbahnen auf einem Trägerfilm Zinn oder eine Blei-Zinn-Legierung und auf den Anschlusskontakten eines Halbleiterchips goldhaltiges Lotmaterial aufgebracht wird.

Aufgabe der vorliegenden Erfindung ist es, ein Verfahren zur Kontaktierung eines Halbleiterbauelementes mit einer metallisierten Kunststofffolie anzugeben, das bei einer Temperatur ausgeführt werden kann, bei der die Folie nicht beschädigt wird, und das eine dauerhafte elektrisch leitende Verbindung ausreichender Leitfähigkeit liefert.

Diese Aufgabe wird mit dem Verfahren mit den Merkmalen des Anspruches 1 gelöst. Ausgestaltungen ergeben sich aus den abhängigen Ansprüchen.

Um das Verständnis der Erfindung zu erleichtern, werden im folgenden Verfahren mit diversen Lotmaterialien beschrieben. Ausführungsformen der Erfindung sind jedoch zur solche Verfahren, bei denen als Lotmaterial BiIn oder BiIn₂ verwendet wird.

Bei den Verfahren wird ein Lotmaterial, vorzugsweise ein Metall, aus mindestens zwei metallischen oder halbleitenden chemischen Elementen auf einen Kontakt des Halbleiterbauelementes oder auf die Metallschicht der Folie an der für eine Kontaktierung vorgesehenen Stelle aufgebracht. Dieses Lotmaterial ist so beschaffen, dass es einen Schmelzpunkt aufweist, der unterhalb einer für die Widerstandsfähigkeit der Folie kritischen Temperatur liegt, und dass es nach dem Schmelzen ein Material bildet, das nach dem Erstarren einen höheren Schmelzpunkt aufweist als das ursprüngliche Lotmaterial. Das geschmolzene Lotmaterial ist vorzugsweise so beschaffen, dass es eine Legierung oder intermetallische Verbindung oder Phase mit dem Metall der Metallschicht der Folie oder mit dem Metall des Kontaktes des Halbleiterbauelementes eingeht. Vorzugsweise liegt dieser Schmelzpunkt so hoch, dass die Folie bei einem Versuch, die Lotverbindung zu schmelzen, unweigerlich beschädigt würde oder zumindest die Metallschicht von der Folie abgelöst und so die gesamte Anordnung unbrauchbar würde.

Ein Lotmaterial, das hierfür besonders geeignet ist, ist eine Zusammensetzung - d. h. eine Mischung aus mindestens und vorzugsweise zwei Komponenten, die ein Gemisch, eine Legierung oder eine stöchiometrische Verbindung bilden - , deren Anteile so gewählt sind, dass die Zusammensetzung an einem eutektischen Punkt oder zumindest in der Nähe eines eutektischen Punktes liegt. Für diese Wahl der Zusammensetzung gilt nämlich, dass sich bei jeder Änderung der Anteile der Komponenten der Schmelzpunkt der Zusammensetzung erhöht. Beim Schmelzen des Lotmaterials wird eine Legierung oder eine intermetallische Verbindung hergestellt, die einen Anteil des Metalls der Metallschicht der Folie oder des Kontaktes des Halbleiterbauelementes enthält, so dass die Zusammensetzung des die elektrisch leitende Verbindung bildenden Materiales von dem Eutektikum der ursprünglichen Zusammensetzung des Lotmaterials so wesentlich verschieden ist, dass der Schmelzpunkt erheblich höher liegt, insbesondere über den für die Folie unschädlichen Temperaturen. Als näherungsweise eutektische Zusammensetzung sei hier eine Zusammensetzung definiert, die einen Schmelzpunkt aufweist, der sich höchstens um 10°C von der Temperatur des Eutektikums unterscheidet.

Als mögliches Lotmaterial, vorzugsweise in Verbindung mit einer Metallschicht der Folie aus Kupfer oder Nickel, kommt vorrangig ein Material in Frage, das Bismut (Wismut, chemisches Zeichen Bi) enthält. Eutektische oder näherungsweise eutektische (Temperaturunterschied zum Eutektikum höchstens 10°C) Zusammensetzungen, die das Gewünschte leisten, sind Materialien aus der Gruppe von Zusammensetzung aus Bismut und Indium, Zusammensetzung aus Bismut und Zinn und Zusammensetzung aus Indium und Zinn. Die eutektischen Zusammensetzungen dieser Materialien in relativen Atommassen sind Bi₂₂In₇₈, Bi₄₃Sn₅₇ bzw. In₅₂Sn₄₈.

Das Material Bi₂₂In₇₈ bildet eine eutektische Zusammensetzung mit dem Schmelzpunkt von 72,7°C. Damit lässt sich eine Lotverbindung bei ca. 80°C herstellen. Das Lotmaterial Bi₂₂In₇₈ wird z. B. auf den Kontakt des Halbleiterbauelementes aufgebracht, was mittels Aufstäubens (sputter) geschehen kann. Das Lotmaterial bildet dann auf dem Kontakt eine dünne Schicht. Diese Schicht wird mit der Metallschicht der Folie in Kontakt gebracht und nach Bedarf unter leichtem Druck gehalten. Durch Erwärmung auf eine Temperatur oberhalb der Schmelztemperatur des Lotmaterials wird das Lotmaterial geschmolzen und legiert mit dem Metall der Metallschicht der Folie zu einem Material, das eine elektrisch leitende Verbindung zwischen dem Kontakt des Halbleiterbauelementes und der Metallschicht der Folie bildet, die bis mindestens 270°C belastbar ist. Bei Verwendung einer Folie, deren Temperaturbelastbarkeit bis maximal etwa 120°C reicht, kann die Verbindung daher problemlos bei etwa 80°C hergestellt werden. Anschließend kann die Verbindung nicht mehr aufgeschmolzen werden, ohne die Folie zu zerstören.

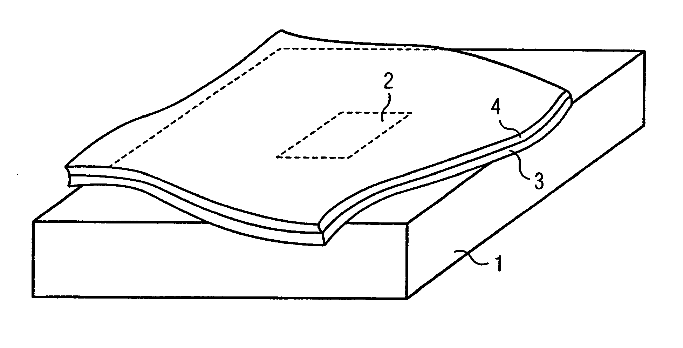

In der beigefügten Figur ist im Schema ein Beispiel einer hergestellten Anordnung eines Halbleiterbauelementes 1 mit einem Kontakt 2 und mit einer auf dem Kontakt angebrachten Metallschicht 3 einer Folie 4 dargestellt. Die Abmessungen der Folie und des Bauelementes, die Anzahl und die Abmessungen der mit der metallisierten Folie verbundenen Kontakte und die Anzahl an Schichten, die die Folie und die Metallschicht bilden, sind beliebig.

Um zu verhindern, dass bei einem Überschuss an Lotmaterial a) die Metallschicht der Folie in ihrer ganzen Dicke mit dem Lotmaterial legiert und sich unter Umständen von der Folie ablöst und b) nicht legiertes Lotmaterial übrig bleibt, das nach wie vor bei niedriger Temperatur, in dem Beispiel bei 72,7°C, schmilzt, wird die Dicke der aufgebrachten Lotschicht vorzugsweise begrenzt. Es wird das Lotmaterial dann nur in einer Schichtdicke aufgebracht, mit der sichergestellt ist, dass das gesamte Lotmaterial mit dem Metall des Kontaktes oder der Metallschicht der Folie eine Legierung oder eine stöchiometrische intermetallische Verbindung eingeht und zumindest ein an der Folie anhaftender Schichtanteil des ursprünglichen Metalls der Metallschicht der Folie unverändert bleibt. Beim Schmelzen des Lotmateriales wird der zwischen dem Kontakt des Halbleiterbauelementes und der Metallschicht der Folie vorhandene Vorrat an Lotmaterial folglich schneller aufgebraucht als das Metall der Metallschicht. Dadurch wird erreicht, dass weder die Metallschicht bis auf die Folie selbst durchlegiert noch unlegiertes Lotmaterial zurückbleibt. Der Schmelzpunkt des Materials der hergestellten Verbindung wird von dem niedrigsten Schmelzpunkt der in der Verbindungszone vorhandenen thermodynamischen Phasen bestimmt.

Bei einem Ausführungsbeispiel, bei dem ein Bauelement mit einer Folie mit einer 100 nm dicken Metallschicht aus Nickel kontaktiert wird, kann auf den Kontakt des Bauelementes eine 100 nm dicke Schicht aus Bi₂₂In₇₈ gesputtert werden. Die elektrisch leitende Verbindung entsteht bei einer Erwärmung auf 80°C innerhalb weniger Sekunden und ist bis 650°C belastbar.

Die oben angegebenen weiteren eutektischen Zusammensetzungen besitzen die Schmelzpunkte 139°C (Bi₄₃Sn₅₇) und 117°C (In₅₂Sn₄₈). Diese Zusammensetzungen können jeweils verwendet werden, wenn die verwendete Folie gefahrlos ein paar Grad Celsius über den betreffenden Temperaturwert erwärmt werden kann. Die intermetallischen Phasen BiIn und BiIn₂, das sind metallische Verbindungen aus Bismut und Indium in stöchiometrischen Verhältnissen, schmelzen bei 109,5°C bzw. bei 89°C. Das sind ebenfalls Temperaturen, die für übliche Kunststofffolien noch unbedenklich sind. Eine intermetallische Phase bietet den Vorteil, dass sie als einzige Phase bei einer bestimmten Temperatur verdampft und nicht wie ein Stoffgemisch mit unterschiedlichen Dampfdrücken der darin enthaltenen Komponenten verdampfen. Verwendet man daher eine solche intermetallische Phase oder stöchiometrische Zusammensetzung als Lotmaterial, ist es möglich, das Lotmaterial mittels Elektronenstrahlverdampfung aufzubringen.

## Patentansprüche

1. Verfahren zur Kontaktierung eines Halbleiterbauelementes (1) mit einer mit einer Metallschicht (3) versehenen Folie (4), bei dem
in einem ersten Schritt ein Lotmaterial, dessen Schmelzpunkt bei einer Temperatur liegt, bei der die Folie nicht beschädigt wird, zwischen einen Kontakt (2) des Halbleiterbauelementes und die Metallschicht der Folie gebracht wird und
in einem zweiten Schritt das Lotmaterial zum Schmelzen und anschließenden Erstarren gebracht wird, so dass eine dauerhafte elektrisch leitende Verbindung aus einem Material mit einem im Vergleich zu dem Schmelzpunkt des aufgebrachten Lotmaterials höheren Schmelzpunkt hergestellt wird, wobei
ein Lotmaterial verwendet wird, das eine intermetallische Verbindung oder Phase der Zusammensetzung BiIn oder BiIn₂ ist.

2. Verfahren nach Anspruch 1, bei dem
in dem ersten Schritt das Lotmaterial mittels Elektronenstrahlverdampfung auf den Kontakt oder die Metallschicht aufgebracht wird.

3. Verfahren nach Anspruch 1 oder 2, bei dem
in dem ersten Schritt das Lotmaterial in einer im Vergleich zu der Dicke der Metallschicht der Folie so begrenzten Schichtdicke aufgebracht wird, dass nach dem zweiten Schritt zumindest ein sich auf der Folie befindender Schichtanteil der Metallschicht unverändert geblieben ist.

## Claims

1. Method for contact-connecting a semiconductor component (1) to a film (4) provided with a metal layer (3), in which
in a first step, a solder material whose melting point is at a temperature at which the film is not damaged is brought between a contact (2) of the semiconductor component at the metal layer of the film, and
in a second step, the solder material is caused to melt and subsequently solidify, thereby producing a permanent electrically conductive connection made of a material having a melting point that is higher than the melting point of the applied solder material, wherein a solder material is used which is an intermetallic compound or phase of the composition BiIn or BiIn₂.

2. Method according to Claim 1, in which,
in the first step, the solder material is applied by means of electron beam vaporization onto the contact or the metal layer.

3. Method according to Claim 1 or 2, in which,
in the first step, the solder material is applied with a layer thickness which is limited in comparison with the thickness of the metal layer of the film such that at least a layer portion of the metal layer that is situated on the film has remained unchanged after the second step.

## Revendications

1. Procédé de mise d'un composant (1) à semi-conducteurs en contact avec une feuille (4) munie d'une couche (3) métallique, dans lequel
dans un premier stade, on met une matière de brasure, qui a un point de fusion auquel la feuille n'est pas endommagé, entre un contact (2) du composant à semi-conducteurs et la couche métallique de la feuille et, dans un deuxième stade, on fait fondre et ensuite se solidifier de la matière de brasure de manière à ménager une liaison conductrice de l'électricité durable en une matière ayant un point de fusion plus haut que le point de fusion de la matière de brasure déposée, en utilisant une matière de brasure qui est un composé ou une phase intermétallique ayant la composition BiIn ou BiIn₂.

2. Procédé suivant la revendication 1, dans lequel
dans le premier stade, on dépose la matière de brasure sur le contact ou sur la couche métallique au moyen d'un dépôt en phase vapeur par jet d'électrons.

3. Procédé suivant la revendication 1 ou 2, dans lequel
dans le premier stade, on dépose la matière de brasure en une épaisseur de couche limitée par rapport à l'épaisseur de la couche métallique de façon à ce que, après le deuxième stade, au moins une proportion de la couche métallique se trouvant sur la feuille reste intacte.
